# EUROPEAN PATENT APPLICATION

(11) **EP 2 579 694 A1**
(43) Date of publication of application: **10.04.2013**
(21) Application number: 11786056.9
(22) Date of filing: 21.05.2011
(51) Int. Cl.: H05K 1/09, H05K 3/32

(54) **CERAMIC PRINTED CIRCUIT BOARD STRUCTURE**

(30) Priority: 25.05.2010 CN 201020201946 U
(71) Applicant: JingDeZhen Fared Technology Co., Ltd, Ceramic Industrial Park Jingdezhen City, 333000 Jiangxi (CN)
(72) Inventor: CHEN, Jeong-Shiun, Jiangxi 333000 (CN)
(74) Representative: Gee, Steven William
(86) International application number: PCT/CN2011/074469
(87) International publication number: WO 2011/147284

(57) **Abstract**

A ceramic printed circuit board (PCB) structure includes a ceramic substrate, silver paste layers and nano-enamel layers. A first silver paste layer of the silver paste layers is provided on the ceramic substrate. The other silver paste layers of the silver paste layers and the nano-enamel layer of the nano-enamel layers are interleaved with each other, and each silver paste layer consists of a circuit pattern for electrically connecting a plurality of electrical elements. Each nano-enamel layer except the last nano-enamel layer of the nano-enamel layers consists of an interlayer electrical connection line for electrically connecting two corresponding circuit patterns on two adjacent nano-enamel layers so as to form the ceramic PCB structure with a multilayer of circuit patterns. The working temperature and the electrical insulation are thus greatly improved.

## Description

### BACKGROUND OF THE INVENTION

### 1. Field of the Invention

The present invention generally relates to a ceramic printed circuit board (PCB) structure, and more specifically to a ceramic PCB structure having a ceramic substrate, a silver paste layer and a nano-enamel layer.

### 2. The Prior Arts

PCBs (printed circuit boards), which support electronic elements to provide electrical insulation are widely used in many electric and electronic applications. In general, the PCB uses the electrically insulated epoxy substrate and the electrically conductive layer of the circuit layer to mount the electronic elements. Finally, the whole surface is covered by an insulation layer such as solder mask to provide protection against moisture and prevent any pollution due to contact.

As the complexity and the precision of the electronic devices increase, the number of the circuit layer of the PCB also increases. That is, the interlayer insulation layer is desired to isolate two adjacent circuit layers, and meanwhile the interlayer connection line in the interlayer insulation layer is used to electrically connect the two adjacent circuit layers. Therefore, it is possible to implement preferred layout with quality to guarantee the electric properties of the electronic elements are not influenced. For instance, to improve the quality of electric signals, the layout of the circuit often follow some guidelines, including the power lines away from the ground lines as far as possible, the lines for high frequency signals isolated with the lines for low frequency signals, and the traces for the digital and the analog signal integrated and confined in the respective regions with special carefulness to avoid any crossover or being too close. As a result, it is possible the electrical quality of the PCB can not be further improved because the effective layout area is shrunk to meet the requirements of thinner and lighter final products.

In particular, the requirements of lower leakage current, higher working voltage and higher working temperature have possibly become much more critical in the upcoming electronic products using lower level of electrical signals, such as most portable electronic devices using the battery as the primary electric power supply. Currently, the PCB with epoxy substrate is often unable to meet what the industries need.

Furthermore, the circuit patterns are formed by the expensive and complicated process of photolithography in the prior arts, which includes at least coating, exposure, developing and etching, and the epoxy substrate can not endure higher temperature. Therefore, it is desired to provide a new a ceramic PCB structure formed of the ceramic substrate and the silver paste without using photolithography so as to overcome the above problems in the prior arts.

### SUMMARY OF THE INVENTION

Therefore, the present invention has been made in view of the above problems, and it is an object of the present invention to provide a ceramic PCB structure including a ceramic substrate, a plurality of silver paste layers and plurality of nano-enamel layers. A first silver paste layer of the silver paste layers is provided on the ceramic substrate, the silver paste layers of the silver paste layers and the nano-enamel layer of the nano-enamel layers are interleaved with each other, and each silver paste layer consists of a circuit pattern for electrically connecting a plurality of electrical elements.

Each nano-enamel layer except the last nano-enamel layer (the uppermost one) of the nano-enamel layers consists of an interlayer electrical connection line for electrically connecting two corresponding circuit patterns on two adjacent nano-enamel layers so as to form the ceramic PCB structure with a multilayer of circuit patterns.

The circuit patterns are formed just by coating and drying the silver paste without the expensive and complicated photolithographic process such that the working temperature and the electrical insulation of the ceramic PCB structure are greatly improved.

### BRIEF DESCRIPTION OF THE DRAWINGS

The present invention can be understood in more detail by reading the subsequent detailed description in conjunction with the examples and references made to the accompanying drawings, wherein:

FIG. 1 is a view schematically showing one embodiment of a ceramic PCB structure according to the present invention; and

FIG. 2 is a view schematically showing another embodiment of the chip-on-board LED structure according to the present invention.

### DETAILED DESCRIPTION OF THE PREFERRED EMBODIMENTS

The present invention may be embodied in various forms and the details of the preferred embodiments of the present invention will be described in the subsequent content with reference to the accompanying drawings. The drawings (not to scale) show and depict only the preferred embodiments of the invention and shall not be considered as limitations to the scope of the present invention. Modifications of the shape of the present invention shall too be considered to be within the spirit of the present invention.

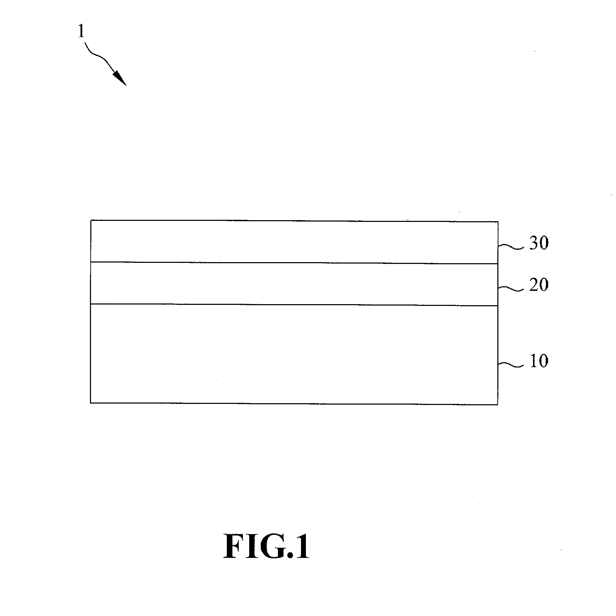

FIG. 1 clearly illustrates one embodiment of the ceramic PCB structure according to the present invention. As shown in FIG. 1, the ceramic PCB structure 1 of the present invention includes a ceramic substrate 10, a silver paste layer 20 and a nano-enamel layer 30. The ceramic substrate 10 has excellent electrical insulation and is made from ceramic material. The silver paste layer 20 is formed on the ceramic substrate 10 by coating and drying the ceramic material such that the silver paste layer 20 has a circuit pattern for electrically connecting a plurality of electrical elements (not visible). The nano-enamel layer 30 has excellent electrical insulation and is formed by sintering nano-particles so as to provide electrical insulation.

The ceramic material of the ceramic substrate 10 consists of one of aluminum oxide, aluminum nitride, zirconium oxide, calcium fluoride and graphite. The silver paste layer 20 consists of high temperature silver paste. The nano-particles of the nano-enamel layer 30 consists of one of aluminum oxide, aluminum nitride, zirconium oxide and calcium fluoride.

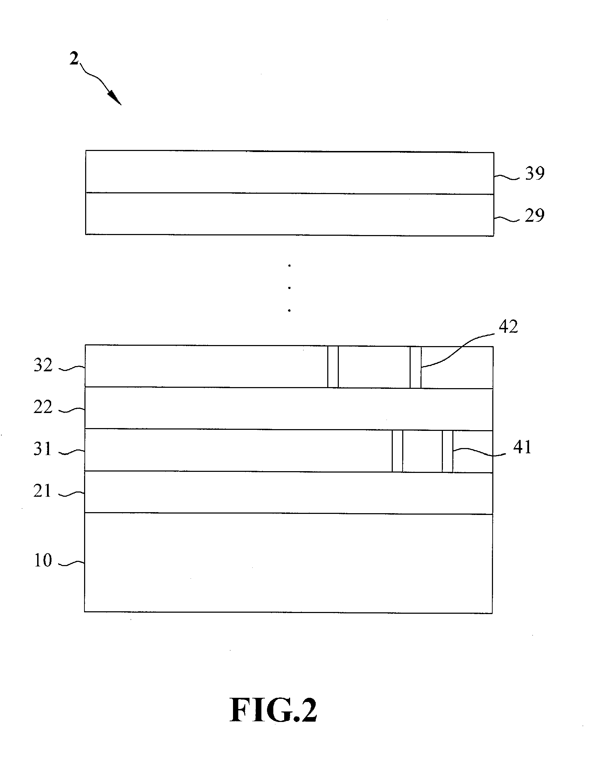

FIG. 2 illustrates another embodiment of the ceramic PCB structure according to the present invention. As shown in FIG. 2, the ceramic PCB structure 2 of the present invention includes a ceramic substrate 10, a plurality of silver paste layers (such as numeral 21, 22, ..., and 29) and a plurality of nano-enamel layers (such as numeral 31, 32, ..., and 39). The first silver paste layer 21 is formed on the ceramic substrate 10 and the first nano-enamel layer 31 is formed on the first silver paste layer 21. Similarly, other silver paste layers and other nano-enamel layers are interleaved with each other and are stacked on the first nano-enamel layer 31 to form the ceramic PCB structure 2 with the last nano-enamel layer 39 formed on the last silver paste layer 29.

The characteristic of the ceramic substrate, the silver paste layers and the nano-enamel layers in FIG. 2 are similar to those in FIG. 1, and the detailed description are thus omitted herein for the sake of brevity.

Each nano-enamel layer except the last nano-enamel layer 39 has an interlayer electrical connection line for electrically connecting two corresponding circuit patterns on two adjacent nano-enamel layers. For example, the first nano-enamel layer 31 has the first interlayer electrical connection line 41 and the second nano-enamel layer 32 has the second interlayer electrical connection line 42. Additionally, the interlayer electrical connection line is formed of electrically conductive material consisting of copper, copper alloy or silver paste.

Therefore, the ceramic PCB structure 2 of the present invention has a multilayer of circuit patterns used for circuit layout and routing.

One aspect of the present invention is that the expensive and complicated process of photolithography is no longer needed and the circuit patterns are formed by a lower cost process, which coats and dries the silver paste. Additionally, the nano-enamel layer is made from ceramic material such that the nano-enamel layer can endure higher temperature than the traditional PCB substrate in the prior arts such as epoxy substrate. Therefore, the complexity and cost of manufacturing the PCB are improved, and the yield of the final product is also increased.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A ceramic printed circuit board (PCB) structure, comprising:
a ceramic substrate electrically insulated and made from ceramic material;
a silver paste layer formed on the ceramic substrate by coating and drying silver paste, wherein the silver paste layer has a circuit pattern for electrically connecting a plurality of electrical elements; and
a nano-enamel layer electrically insulated and formed by sintering nano-particles to cover the silver paste layer and the electrical elements for providing electrical insulation and protection.

2. The ceramic PCB structure as claimed in claim 1, wherein the ceramic material consists of one of aluminum oxide, aluminum nitride, zirconium oxide, calcium fluoride and graphite.

3. The ceramic PCB structure as claimed in claim 1, wherein the nano-particles consist of one of aluminum oxide, aluminum nitride, zirconium oxide and calcium fluoride.

4. The ceramic PCB structure as claimed in claim 1, wherein the silver paste constituting the silver paste layer has high temperature.

5. A ceramic printed circuit board (PCB) structure, comprising:
a ceramic substrate electrically insulated and made from ceramic material;
a plurality of silver paste layers formed by coating and drying silver paste; and
a plurality of nano-enamel layers electrically insulated and formed by sintering nano-particles;
wherein, each silver paste layer consists of a circuit pattern for electrically connecting a plurality of electrical elements, a first silver paste layer of the silver paste layers is provided on the ceramic substrate, a first nano-enamel layer of the nano-enamel layers covers the first silver paste layer and the electrical elements on the first silver paste layer, other silver paste layers of the silver paste layers and other nano-enamel layers of the nano-enamel layers are interleaved with each other and are stacked on the first nano-enamel layer to form the ceramic PCB structure with a multilayer of circuit patterns, each nano-enamel layer except a last nano-enamel layer of the nano-enamel layers consisting of an interlayer electrical connection line for electrically connecting two corresponding circuit patterns on two adjacent nano-enamel layers, and the interlayer electrical connection line is formed of electrically conductive material consisting of copper, copper alloy or silver paste.

6. The ceramic PCB structure as claimed in claim 5, wherein the ceramic material consists of one of aluminum oxide, aluminum nitride, zirconium oxide, calcium fluoride and graphite.

7. The ceramic PCB structure as claimed in claim 5, wherein the nano-particles consist of one of aluminum oxide, aluminum nitride, zirconium oxide and calcium fluoride.

8. The ceramic PCB structure as claimed in claim 5, wherein the silver paste constituting the silver paste layer has high temperature.
